# EUROPEAN PATENT APPLICATION

(11) **EP 1 638 178 A1**
(43) Date of publication of application: **22.03.2006**
(21) Application number: 03817205.2
(22) Date of filing: 20.06.2003
(51) Int. Cl.: H01S 3/06, H01S 3/0941, H01S 3/042

(54) **SOLID LASER EXCITATION MODULE**

(71) Applicant: MITSUBISHI DENKI KABUSHIKI KAISHA, Tokyo 100-8310 (JP)
(72) Inventor: YAMAMOTO, Shuhei, MITSUBISHI DENKI K. K., Tokyo 100-831 (JP); KANAGISAWA, Takayuki, MITSUBISHI DENKI K. K., Tokyo 100-8310 3 (JP); HIRANO, Yoshihito, MITSUBISHI DENKI K. K., Tokyo 100-8310 (JP)
(74) Representative: Pfenning, Meinig & Partner GbR
(86) International application number: PCT/JP2003/007884
(87) International publication number: WO 2004/114476

(57) **Abstract**

A solid state laser pumping module (1) is so constructed as to have a plate-shaped non-doped medium (4) having a refractive index close to that of a thin solid state laser medium (3) and having no active material, the non-doped medium being disposed on a surface of the thin solid state laser medium (3) which is opposite to a reflecting surface of the thin solid state laser medium (3). Pumping light is reflected between the reflecting surface of the thin solid state laser medium (3) and a reflecting surface of the non-doped medium (4) arranged on a side of the opposite surface of the thin solid state laser medium (3) while pumping the thin solid state laser medium (3). A laser beam is taken out of the thin solid state laser medium.

## Description

### Field of the Invention

The present invention relates to a solid state laser pumping module that uses a thin solid state laser medium.

### Background of the Invention

Conventionally, there has been provided a solid state laser pumping module that is so constructed as to pump a thin solid state laser medium. Such a solid state laser pumping module has a pumping source arranged opposite to a thin plate which is a solid state laser medium, and is so constructed as to pump this thin solid state laser medium. Such a technology is disclosed in, for example, United States Patent Number: 5,553,088, by Braich et al., on Sep. 3, 1996.

The related art solid state laser pumping module using the thin solid state laser medium needs to enlarge side surfaces of the thin solid state laser medium which are pumping surfaces in order to raise the proportion of pumping light incident upon the side surfaces because it is so constructed as to receive pumping light from the side surfaces of the thin solid state laser medium. Especially, since a high-power pumping source has a luminescence surface of a large size, even if pumping light emitted out of the pumping source is focused by a lens or the like, the pumping light has a large size in cross section at its focus point. Therefore, in order to pump the related art solid state laser pumping module with a high degree of efficiency, the side surfaces which are the pumping surfaces need to be enlarged. For this reason, since the thin solid state laser medium of the related art solid state laser pumping module needs to have a large thickness and therefore the temperature of the thin solid state laser medium which is a heating element increases, the efficiency of the laser oscillation and the laser output power decreases. On the other hand, when the thickness of the thin solid state laser medium is reduced in order to suppress the temperature rise of the laser medium, the proportion of the pumping light incident upon the thin solid state laser medium is low and this results in decrease in the power of the output laser light.

In a related art solid state laser pumping module using a thin solid state laser medium, which is so constructed as to introduce pumping light into a side surface or a plane surface of the thin solid state laser medium, a reflecting coating which reflects light having laser oscillation wavelengths is generally formed on one plane surface of the thin solid state laser medium, and therefore the thin solid state laser medium may be distorted under the influence of a stress produced in the reflecting coating. Since it is difficult to control the amount of this stress distortion, the stress distortion differs every time the related art solid state laser pumping module is manufactured. Such the distortion of the thin solid state laser medium causes a large loss at the time of laser oscillation, the power of high-quality laser beams, especially the power of a single mode laser beam and low-order multimode laser beams, is reduced greatly. Since the stress distortion differs every time the related art solid state laser pumping module is manufactured, the power and beam quality of the output laser light differ every time the related art solid state laser pumping module is manufactured.

Since the thin solid state laser medium has two plane surfaces which are opposite and parallel to each other, an etalon effect occurs in the thin solid state laser medium and hence wavelength dependability of the transmissivity of the laser light arises. For this reason, the laser oscillation does not take place throughout the gain band of the thin solid state laser medium, and the laser oscillation is carried out at discontinuous wavelengths or in only a partial wavelength region. The parallelism of the two plane surfaces of the thin solid state laser medium which are opposite to each other may be intentionally reduced in order to prevent such an etalon effect. However, when such a measure of reducing the parallelism of the two plane surfaces of the thin solid state laser medium is used, the gain distribution in a plane parallel to the plane surfaces becomes less uniform since the thickness of the thin solid state laser medium differs in the plane. This results in degradation in the beam quality of the output laser light and reduction in the laser power of the high-quality output laser light.

Thus, a problem with a related art solid state laser pumping module using a thin solid state laser medium is that the pumping surface of the thin solid state laser medium cannot be enlarged sufficiently, and it is therefore difficult to pump the thin solid state laser medium with a high degree of efficiency using a high-power pumping source and hence coexistence of improvements in the efficiency of the pumping and increase in the power of the output laser light is difficult. Another problem is that since the solid state laser medium cannot be thinned sufficiently, the temperature rise of the solid state laser medium becomes large and it is therefore difficult to carry out high-efficiency high-power laser oscillation. A further problem is that since the thin solid state laser medium is distorted by a stress produced in a reflecting coating formed on a surface of the thin solid state laser medium, high-quality output laser light cannot be obtained with a high degree of efficiency and with high power, or the beam quality of the output laser light degrades. A still further problem is that since it is difficult to control the amount of distortion produced in the solid state laser medium, the beam quality and power of the output laser light differ every time the related art solid state laser pumping module is manufactured. Another problem is that since the gain distribution in a plane parallel to the surface becomes less uniform when the thickness of the thin solid state laser medium in the plane is varied along its length in order to prevent an etalon effect from occurring in the thin solid state laser medium, the beam quality of the output laser light degrades or the power of the high-quality output laser light decreases.

### Disclosure of the Invention

In accordance with the present invention, there is provided a solid state laser pumping module including a reflecting coating formed on a plane surface of a thin solid state laser medium into which an active material is partially doped or doped over a whole of the plane surface, and having a structure in which heat is exhausted from the plane surface thereof on a side of the reflecting coating. In addition, a plate-shaped non-doped medium having a refractive index close to that of the thin solid state laser medium and having no active material is disposed on another plane surface of the thin solid state laser medium which is opposite to the plane surface of the thin solid state laser medium on which the reflecting coating is formed.

Therefore, since any temperature rise of the thin solid state laser medium can be suppressed, occurrence of stress distortions of the thin solid state laser medium and parasitic oscillations can be prevented, and the gain region of the thin solid state laser medium can be formed into an arbitrary shape, the present invention offers an advantage of being able to provide high-power laser light with a high degree of efficiency.

The solid state laser pumping module in accordance with the present invention can be so constructed as to have a pumping surface which is side surfaces of the plate-shaped thin solid state laser medium and the non-doped medium, and via which pumping light is introduced thereinto, so that the pumping light propagates through the thin solid state laser medium and pumps the thin solid state laser medium while being reflected between the plane surface of the thin solid state laser medium on which the reflecting coating is formed and a plane surface of the non-doped medium which is opposite to the thin solid state laser medium.

Therefore, the present invention offers another advantage of being able to enlarge the size of the pumping surface regardless of the thickness of the thin solid state laser medium.

The solid state laser pumping module in accordance with the present invention can be constructed so that the pumping surface is inclined with respect to a direction of the thickness of the thin solid state laser medium, and the optical axis of the pumping light outputted from the pumping source is inclined toward a direction which is the same as a direction toward which the pumping surface is inclined.

Therefore, the present invention offers an advantage of being able to suppress an etalon effect and parasitic oscillations.

In the solid state laser pumping module in accordance with the present invention, either of diffusion bonding, optical contact, and a ceramic manufacturing means can be used to bond the thin solid state laser medium and the non-doped medium to each other.

Therefore, the present invention offers another advantage of being able to provide a high-strength solid state laser chip having little optical loss in which the thin solid state laser medium and the non-doped medium are bonded to each other.

The solid state laser pumping module in accordance with the present invention can be constructed so that the plane surfaces of the thin solid state laser medium are parallel to each other, and the plane surfaces of the non-doped medium are inclined with respect to each other.

Therefore, the present invention offers a further advantage of being able to suppress an etalon effect and parasitic oscillations.

In the solid state laser pumping module in accordance with the present invention, the active material of the thin solid state laser medium can be Yb.

Therefore, since there is not so much influence of heat generation peculiar to the solid state laser medium, and concentration rise and fall hardly occur, the present invention offers a still further advantage of being able to reduce the physical size of the solid state laser pumping module and to form super-short laser light pulses.

### Brief Description of the Figures

Fig. 1 is a side view of a solid state laser pumping module in accordance with embodiment 1 of the present invention;
Fig. 2 is a diagram showing the structure of a main part of the solid state laser pumping module in accordance with embodiment 1 of the present invention;
Fig. 3 is a side view of a solid state laser chip in accordance with embodiment 1 of the present invention;
Fig. 4 is a block diagram of a laser oscillator which employs the solid state laser pumping module in accordance with embodiment 1 of the present invention;
Fig. 5 is a block diagram of another example of the laser oscillator which employs the solid state laser pumping module in accordance with embodiment 1 of the present invention;
Fig. 6 is a diagram showing the structure of a main part of a second example of the solid state laser pumping module in accordance with embodiment 1 of the present invention;
Fig. 7 is a diagram showing the structure of a main part of a third example of the solid state laser pumping module in accordance with embodiment 1 of the present invention;
Fig. 8 is a plan view of a fourth example of the solid state laser pumping module in accordance with embodiment 1 of the present invention;
Fig. 9 is a diagram showing the structure of a main part of a solid state laser pumping module in accordance with embodiment 2 of the present invention;
Fig. 10 is a plan view of a thin solid state laser medium composite material of a solid state laser chip in accordance with embodiment 3 of the present invention; and
Fig. 11 is a side view of the solid state laser chip in accordance with embodiment 3 of the present invention.

### Preferred Embodiments of the Invention

Hereafter, in order to explain this invention in greater detail, the preferred embodiments of the present invention will be described with reference to the accompanying drawings.

### Embodiment 1.

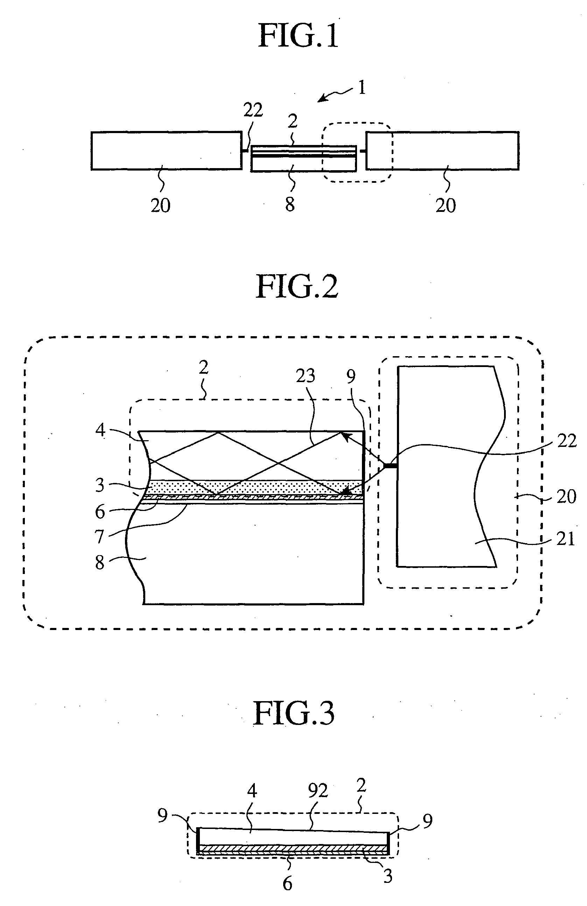

Fig. 1 is a side plan view of a solid state laser pumping module in accordance with embodiment 1, and Fig. 2 is a diagram showing the structure of a main part of the solid state laser pumping module in accordance with embodiment 1.

The solid state laser pumping module 1 in accordance with embodiment 1 is provided with a solid state laser chip 2, a pumping source 20, and a cooling means 8, as shown in Figs. 1 and 2. The solid state laser chip 2 is comprised of a thin solid state laser medium 3, a non-doped medium 4, and a reflecting coating 6.

The thin solid state laser medium 3 is a laser medium into which a rare earth material is doped as an active material, and includes, as its base material, such a material as a crystal, ceramics, or glass material. In this embodiment, although the rare earth material doped into the thin solid state laser medium is not limited and any of various rare earth materials can be used as the doped rare earth material, a case where Yb (ytterbium) is used as the doped rare earth material will be explained hereafter. Furthermore, although the base material of the thin solid state laser medium is not limited in this embodiment and any of various base materials can be used as the base material of the thin solid state laser medium, a case where Y₃Al₅O₁₂ (YAG) is used as the base material of the thin solid state laser medium will be explained hereafter. Such YAG into which Yb is doped is called Yb:YAG.

The non-doped medium 4 is formed on a surface of the thin solid state laser medium 3 which is opposite to another surface of the thin solid state laser medium 3 on which the reflecting coating 6 is formed, and is plate-shaped and is optically transparent. The non-doped medium 4 has a refractive index close to that of the thin solid state laser medium 3, but does not have the active material which is doped into the thin solid state laser medium 3. In other words, either of a crystal, ceramics, or glass material, or the like can be used as the non-doped medium 4, as in the case of the base material of the thin solid state laser medium 3 , and no laser material is doped into the non-doped medium 4.

The solid state laser chip 2 in accordance with this embodiment is pumped by the pumping source 20 from a lateral side surface thereof. In the solid state laser chip 2, since the thin solid state laser medium 3 and the non-doped medium 4 are bonded to each other so that they are integral with each other, a light incidence surface via which pumping light from the pumping source is incident into the solid state laser chip is the lateral side surface which is a united one of a lateral side surface of the thin solid state laser medium 3 and a lateral side surface of the non-doped medium 4. This united surface is a pumping surface 9. The pumping light source 20 can be a semiconductor laser. Especially, the pumping light source 20 can be a semiconductor laser bar which can efficiently emit high-power pumping light. For example, the pumping light source 20 has a semiconductor laser 21 including a single-layer semiconductor laser bar 22 so as to pump the solid state laser chip. The semiconductor laser bar 22 can have a light emitting surface having a size of several micrometers in a direction of the fast axis thereof, and having a size of about 10mm in a direction of the slow axis thereof. In such a case, when the solid state laser pumping module is formed so that the pumping surface 9 has a size in a direction (referred to as a width direction) perpendicular to the direction of the thickness of the solid state laser chip 2, the size being equal to or larger than that of the semiconductor laser 21 in the direction of the slow axis thereof, and the distance between the semiconductor laser bar 22 and the pumping surface 9 is equal to or shorter than the distance of the solid state laser chip 2 in the direction of the thickness thereof, almost all the pumping light can be efficiently incident upon the solid state laser chip 2 via the pumping surface 9. The pumping light 23 incident upon the solid state laser chip 2 via the pumping surface 9 propagates through the solid state laser chip 2 while being repeatedly total-reflected within the solid state laser chip 2. When the propagating pumping light 23 passes through the thin solid state laser medium 3, the pumping light 23 is absorbed by the thin solid state laser medium 3. Thus, while the pumping light 23 propagates zigzag through the interior of the solid state laser chip 2, it is absorbed by the thin solid state laser medium 3 and the thin solid state laser medium 3 is pumped by the pumping light.

The semiconductor laser light is emitted in the direction of the first axis of the semiconductor laser with a large spread angle. For example, the semiconductor laser light can be emitted out of the semiconductor laser with a spread angle of 40 degrees at full width at half maximum. Therefore, since light components having large spread angles of the pumping light 23 which is incident upon the solid state laser chip via the pumping surface 9 are incident upon the surface of the thin solid state laser medium 3 (referred to as a lower surface of the solid state laser chip from here on), on which the reflecting coating 6 is formed, at large angles, and are also incident upon a surface of the non-doped medium 4 (referred to as an upper surface of the solid state laser chip from here on), which is opposite to another surface of the non-doped medium 4 which is bonded to the thin solid state laser medium, at large angles, those light components are total-reflected by the lower and upper surfaces. Therefore, when propagating through the interior of the solid state laser chip, the light components having large spread angles of the pumping light 23 are total-reflected a large number of times by the upper and lower surfaces of the solid state laser chip and propagates zigzag. On the other hand, other light components having small spread angles of the pumping light 23 propagates through the interior of the solid state laser chip while being total-reflected a small number of times by the upper and lower surfaces of the solid state laser chip.

Assuming that the thin solid state laser medium which constitutes the solid state laser chip in accordance with the present invention has a thickness of d1 and the non-doped medium has a thickness of d2, the solid state laser chip has a thickness of d0 equal to d1+d2. Furthermore, it is assumed that a related art thin solid state laser medium has a thickness of D1, and has a size of L in a direction of its length which is perpendicular to the pumping surface thereof. For example, when the thickness d1 of the thin solid state laser medium of the solid state laser chip in accordance with the present invention is equal to the thickness D1 of the related art thin solid state laser medium and the thickness d1 of the thin solid state laser medium is m times the thickness d2 of the non-doped medium, d1=D1, d2=mxd1, and d0=d1+d2=(m+1)d1.

It can be therefore seen that in accordance with this embodiment, since the pumping surface of the thin solid state laser medium in accordance with the present invention has a size which is (m+1) times that of the pumping surface of the related art thin solid state laser medium and the aperture of the pumping surface of the thin solid state laser medium in accordance with the present invention is (m+1) times that of the pumping surface of the related art thin solid state laser medium, the pumping light can be easily made to be incident upon the solid state laser chip in accordance with the present invention via the pumping surface. On the other hand, since the pumping light is not absorbed by the solid state laser chip 2 in accordance with this embodiment when passing through the non-doped medium 4, an absorption length which is equal to a length which the pumping light passes through the solid state laser medium is reduced to 1/(m+1) of that of the related art thin solid state laser medium.

Therefore, in order to provide an absorption length equal to that of the related art thin solid state laser medium, the thin solid state laser medium in accordance with the present invention needs to have a size which is (m+1) times that of the related art thin solid state laser medium, i.e., a size of (m+1)L in the direction of its length which is perpendicular to the pumping surface thereof. In this case, the thin solid state laser medium in accordance with the present invention can provide an absorption equal to that provided by the related art thin solid state laser medium. In addition, since the absorption rate per unit length of the pumping light increases with increase in the concentration of the active material contained in the thin solid state laser medium, the absorption rate can be kept constant even when the absorption length is short.

For example, since the absorption rate per unit length also becomes (m+1) times that of the related art thin solid state laser medium when the concentration of the active material is increased to (m+1) times that of the active material contained in the related art thin solid state laser medium, the same absorption rate as that of the related art thin solid state laser medium can be secured even when the absorption length is reduced to 1/ (m+1) of that of the related art thin solid state laser medium. Especially, when the active material is Yb and the base material is YAG, it is possible theoretically to replace 100% of YAG with Yb. It is therefore easy to dope a high concentration of Yb into YAG so as to provide a large absorption rate per unit length.

Therefore, since the solid state laser pumping module in accordance with this embodiment employs the solid state laser chip 2 in which the thin solid state laser medium 3, into which a high concentration of active material is doped, and the non-doped medium 4 are bonded to each other, it is possible to widen the pumping surface without thickening the thin solid state laser medium 3 and it is possible to make the pumping light be absorbed by the thin solid state laser medium 3 without enlarging the outer size of the solid state laser chip 2.

Thus, since the size of the pumping surface in the direction of the thickness of the solid state laser chip can be enlarged, a pumping source having a large light emitting surface, such as a laminated semiconductor laser bar, can be alternatively used. In this case, the solid state laser pumping module can be pumped with high power and therefore high-power output laser light can be obtained.

The temperature of the thin solid state laser medium which is a heating element increases with increase in its thickness. In the solid state laser pumping module in accordance with this embodiment, since the thickness of the thin solid state laser medium 3 can be thinned regardless of the pumping source, it is possible to sufficiently reduce the thickness of the thin solid state laser medium 3. As a result, the increase in the temperature of the thin solid state laser medium 3 can be suppressed to a very small value. Thus, since the increase in the temperature of the thin solid state laser medium 3 is small, laser oscillation can be carried out with a high degree of efficiency and with high power. Furthermore, when a laser amplifier is so constructed as to have this structure, the laser amplifier can have a high gain. In this case, the laser amplifier can provide energy with a high degree of efficiency and carry out high-power amplification.

In a case where heat is exhausted from an end surface of the thin solid state laser medium, a reflecting coating for reflecting light having a wavelength equal to that of laser light incident upon the solid state laser module is formed on the end surface of the thin solid state laser medium from which heat is exhausted and the thin solid state laser medium is used as a reflecting mirror having a gain. The thinner the thickness of the thin solid state laser medium, the smaller the increase in the temperature of the thin solid state laser medium, and the thinner thickness of the thin solid state laser medium is advantageous for greater efficiency of the laser oscillation and greater power, as previously mentioned. On the other hand, when the thickness of the thin solid state laser medium is too thin, distortion may occur in the thin solid state laser medium due to a stress by the reflecting coating. Although the distorted thin solid state laser medium operates as a reflecting surface having a curvature, the distortion does not have an ideal spherical or parabolic distribution, but the distorted thin solid state laser medium becomes a reflecting surface with a high order aberration. Since the high order aberration cannot be corrected easily by neither a spherical lens nor a cylindrical lens, the laser beam quality degrades and the laser power decreases depending on the amount of the produced aberration. In general, since it is difficult to control the stress by the reflecting coating, it is difficult to control the amount of the distortion. For this reason, a related art solid state laser chip differs in its laser beam quality and output every time it is manufactured.

In contrast, the solid state laser chip 2 in accordance with this embodiment is constructed so that the surface of the thin solid state laser medium 3 which is opposite to the other surface on which the reflecting coating 6 is formed is optically bonded to the non-doped medium 4. The non-doped medium 4 has a larger thickness than the thin solid state laser medium 3, and is bonded to the thin solid state laser medium 3 over the whole surface thereof. Thus, since the thin solid state laser medium 3 and the non-doped medium 4 are bonded to each other over the whole surfaces thereof, the solid state laser chip 2 has greater rigidity than the single thin solid state laser medium 3 and the amount of distortion that occurs in the solid state laser chip 2 due to a stress by the reflecting coating 6 becomes very small. For this reason, the solid state laser pumping module in accordance with the present invention exhibits a characteristic in which neither degradation of the beam quality of the output laser light depending on distortion that occurs in the solid state laser chip nor decrease in the power of the laser light with a high beam quality occurs, and the solid state laser pumping module can provide a high-beam-quality high-power laser output. Furthermore, while the solid state laser pumping module in accordance with the present invention does not exhibit a characteristic in which the output laser light differs in its power and beam quality every time it is manufactured, the solid state laser pumping module has an advantage of being able to provide a stable-quality laser output having stable power.

In accordance with this embodiment, the thin solid state laser medium 3 and the non-doped medium 4 can be bonded to each other using a technique called diffusion bonding. According to the diffusion bonding, the thin solid state laser medium 3 and the non-doped medium 4 are boned to each other by heating their surfaces to be bonded to each other to high temperatures after exerting a pressure on the two surfaces. Thus, the bonded surfaces have little optical loss and have a large strength. According to the diffusion bonding, when two materials to be bonded to each other have refractive indices close to each other, they can be bonded to each other with a high degree of quality. Therefore, the base material of the thin solid state laser medium 3 can be the same as the material from which the non-doped medium 4 is made. For example, when the thin solid state laser medium 3 is Yb:YAG, the non-doped medium 4 can be YAG. In this case, Yb:YAG and YAG can be handled as a chip having great rigidity and having no optical loss.

The solid state laser chip 2 in which the thin solid state laser medium 3 and the non-doped medium 4 are bonded to each other as one chip is pumped by the pumping source 20. Since no active material is doped into the non-doped medium 4, but an active material is doped into only the thin solid state laser medium 3, the pumping light 23 is absorbed only by the thin solid state laser medium 3. Therefore, heat is generated only in the thin solid state laser medium 3, whereas no heat is generated in the non-doped medium 4.

Heat is exhausted from the surface of the thin solid state laser medium 3 on which the reflecting coating 6 is formed. For this reason, the increase in the temperature of the thin solid state laser medium 3 of the solid state laser chip 2 is the same as that in the temperature of a single thin solid state laser medium having the same thickness as the thin solid state laser medium 3 of the solid state laser chip 2 and having the same amount of heat generation as the thin solid state laser medium 3. Therefore, even when the thickness of the thin solid state laser medium 3 in a direction of heat transfer is thinned to 100 micrometers or less, the solid state laser chip has great rigidity and the distortion due to the stress by the reflecting coating 6 is very small, and the increase in the temperature of the thin solid state laser medium can be suppressed to a low value because the thin solid state laser medium is bonded to the non-doped medium 4. Thus, in accordance with this embodiment, since the distortion of the solid state laser chip 2 can be reduced greatly, neither degradation of the laser beam quality nor decrease in the laser power occurs. Furthermore, since the thickness of the thin solid state laser medium 3 can be thinned, the solid state laser pumping module offers an advantage of being able to reduce the increase in the temperature of the thin solid state laser medium and to provide high-power laser light with a high degree of efficiency.

As described above, the solid state laser chip 2 is the one in which the thin solid state laser medium 3 and the non-doped medium 4 are bonded to each other using diffusion bonding. As an alternative, the solid state laser chip 2 in which the thin solid state laser medium 3 and the non-doped medium 4 are bonded to each other can be formed using an optical contact technique or a ceramic manufacturing technique for unifying two powdered media by laminating and sintering them. As previously mentioned, the base material of the thin solid state laser medium is the same as the material from which the non-doped medium is made. As an alternative, the non-doped medium 4 can be made from a material that is optically transparent, and that has a refractive index close to that of the thin solid state laser medium 3. In this variant, the above-mentioned diffusion bonding or the technique for manufacturing ceramics can be similarly used to bond the thin solid state laser medium 3 and the non-doped medium 4 together. For example, the thin solid state laser medium 3 can be Yb:YAG, and the non-doped medium can be made from sapphire. Since the sapphire is an optically-transparent high-rigidity material, and has a feature of being able to reduce the amount of distortion in the non-doped medium due to stress to a very small one.

The cooling means 8 is bonded to the surface of the thin solid state laser medium 3, on which the reflecting coating 6 is formed, with a bonding agent 7. The bonding agent 7 can be an adhesive, metallic material, or alloy. For example, a metallic film, such as a gold or copper film, is formed on the reflecting coating 6 and the metallic film is alloyed with a solder material such as indium, so that the cooling means 8 is bonded to the reflecting coating formed on the thin solid state laser medium 3. When the cooling means 8 is thus bonded to the reflecting coating formed on the thin solid state laser medium 3, the bonding strength is enhanced and the thermal resistance is reduced.

A heat sink which constitutes the cooling means 8 can have a suitable channel through which such a cooling medium as a fluid or gas is passed. In this case, water, ethylene glycol, alcohol, ammonia, mercury, liquid nitrogen, liquid helium, or the like can be used as the fluid, and a helium gas or the like is suitable for the gas. As an alternative, the cooling means 8 can be bonded to a plate which is independently cooled, or can be bonded to a Peltier element so that it is cooled by the Peltier element. In either of the cases, since the solid state laser chip 2 is constructed so that the surface of the thin solid state laser medium 3 on which the reflecting coating 6 is formed is thermally and mechanically bonded to the heat sink 8 with the bonding agent 7, the heat produced in the thin solid state laser medium 3 flows in a single dimension toward the cooling means 8. For this reason, in the thin solid state laser medium 3, a temperature distribution occurs only in a cross section in the direction of the thickness thereof, and the thin solid state laser medium 3 has a temperature distribution in which the temperature of the surface thereof on which the reflecting coating 6 is formed is the lowest and that of the other surface thereof to which the non-doped medium 4 is bonded is the highest. On the other hand, since heat conduction is carried out in a single dimension within the solid state laser chip 2, no temperature distribution occurs in a plane perpendicular to the direction of the thickness of the solid state laser chip 2, i.e., a plane parallel to the cross section of the laser beam which is pumped by the solid state laser chip, and therefore no heat lens effect is produced. Therefore, the present embodiment offers an advantage of being able to prevent the operational stability region from changing in connection with the pumping or the laser power, and being able to provide a high-power high-quality laser beam with stability.

The thin solid state laser medium, which is pumped by the pumping light of sufficient intensity, produces fluorescence and has an optical gain. For this reason, laser oscillation can be carried out when a suitable partial reflection mirror is arranged so that a resonator is constructed. On the other hand, since the thin solid state laser medium is thin and has an optical gain in its small region, there is a possibility that a not-intended laser oscillation takes place. For example, laser oscillation may take place between the two upper and lower surfaces of the thin solid state laser medium or between side surfaces of the thin solid state laser medium which are opposite to each other, or produced fluorescence may be total-reflected repeatedly between the above-mentioned two surfaces of the thin solid state laser medium and increase the amount of fluorescence, so that the optical gain of the solid state laser chip is reduced. This phenomenon is called occurrence of ASE (Amplified Spontaneous Emission). In extreme cases, an unnecessary laser oscillation which is called a parasitic oscillation takes place. Since the parasitic oscillation cannot be taken out of the solid state laser chip as a desired laser beam, and reduces the optical gain of the solid state laser chip, the power of the desired laser beam emitted out of the output mirror may be saturated and may be further reduced even if the power of the pumping light applied to the solid state laser chip is increased. For this reason, in the case of a thin medium made from Yb:YAG in which a small region has to be pumped by high-power-density pumping light, there is particularly a necessity to suppress parasitic oscillations as mentioned above.

When a thin solid state laser medium is used alone without being bonded to a non-doped medium, fluorescence which is produced at an angle which satisfies total reflection conditions within the thin solid state laser medium is repeatedly total-reflected between the two upper and lower surfaces of the thin solid state laser medium, and therefore reduces the optical gain of the thin solid state laser medium. On the other hand, in the case of the solid state laser chip 2 in accordance with the present invention, since fluorescence produced in the thin solid state laser medium 3 is total-reflected between the upper and lower surfaces of the solid state laser chip 2, the length through which the produced fluorescence is passed within the thin solid state laser medium becomes short by a length corresponding to the thickness of the non-doped medium bonded to the thin solid state laser medium, and the amount of reduction in the optical gain of the thin solid state laser medium is reduced. Therefore, the solid state laser pumping module in accordance with the present invention offers an advantage of being able to prevent parasitic oscillations from easily occurring and to provide a high-power laser beam with a high degree of efficiency.

The solid state laser chip 2 can be constructed so that the parallelism of the two upper and lower surfaces thereof is reduced in order to suppress parasitic oscillations.

When a parallel plate exists in a laser cavity, wavelength dependability which is called an etalon effect and by which only a light beam having a resonance wavelength is selectively amplified may occur under the influence of optical resonance caused by reflection at both end surfaces of the parallel plate. In the case of a related art solid state laser pumping module in which a reflecting coating is formed on a lower surface of a thin solid state laser medium and has a high reflectivity, an etalon effect may occur in the thin solid state laser medium under the influence of multipath reflection between the upper and lower surfaces of the thin solid state laser medium even if the reflectivity of the upper surface is small. In the case of a single thin solid state laser medium, there is a necessity to reduce the parallelism of the upper and lower surfaces of the thin solid state laser medium itself in order to reduce the etalon effect between the upper and lower surfaces of the thin solid state laser medium. Thus, when the single thin solid state laser medium is so constructed, the thickness of the laser medium having a gain differs from position to position in the cross section of the laser beam. Therefore, since the amplification factor of the laser medium differs from position to position in the cross section of the laser beam, the beam quality of the laser beam may degrade.

In order to solve this problem, in accordance with this embodiment, the parallelism of the two upper and lower surfaces of the plane-shaped solid state laser chip 2 is intentionally reduced, as shown in Fig. 3. As shown in this figure, the free surface of the non-doped medium, which is opposite to the other surface of the non-doped medium to which the thin solid state laser medium 3 is bonded, is inclined with respect to the other surface, and is called an inclined surface 92 of the non-doped medium. Thus, since the non-doped medium 4 has the inclined surface 92, the optical paths of light beams repeatedly reflected between the upper and lower surfaces of the solid state laser chip 2 are not in agreement with one another, and multiplex interference does not take place. For this reason, since no etalon effect occurs and the light beam passing through the solid state laser chip does not have wavelength dependability, continuous laser oscillation and amplification can be carried out in a laser gain band and ideal formation of super-short laser pulses can be carried out.

Since the solid state laser chip 2 of this variant is constructed so that the thin solid state laser medium 3 and the non-doped medium 4 having the inclined plane 92 are bonded to each other, the etalon effect and parasitic oscillations can be suppressed even though the thickness of the thin solid state laser medium having a gain is kept constant over the length thereof. Therefore, the present embodiment offers an advantage of being able to provide a high-quality laser beam without degrading the beam quality of the laser beam since the amplification factor of the solid state laser medium is kept constant over the cross section of the laser beam. This variant of the present embodiment offers another advantage of suppressing parasitic oscillations resulting from reflection at the upper and lower surfaces of the solid state laser chip 2. As shown in Fig. 3, in accordance with this variant, by changing the thickness of the non-doped medium 4 along the direction perpendicular to the two pumping surfaces 9, the parallelism of the upper and lower side surfaces of the solid state laser chip is reduced. As an alternative, the parallelism of the upper and lower side surfaces of the solid state laser chip can be reduced by changing the thickness of the non-doped medium 4 along a direction perpendicular to side surfaces of the solid state laser chip other than the two pumping surfaces.

Next, a laser oscillator using the solid state laser pumping module 1 which is constructed as mentioned above will be explained.

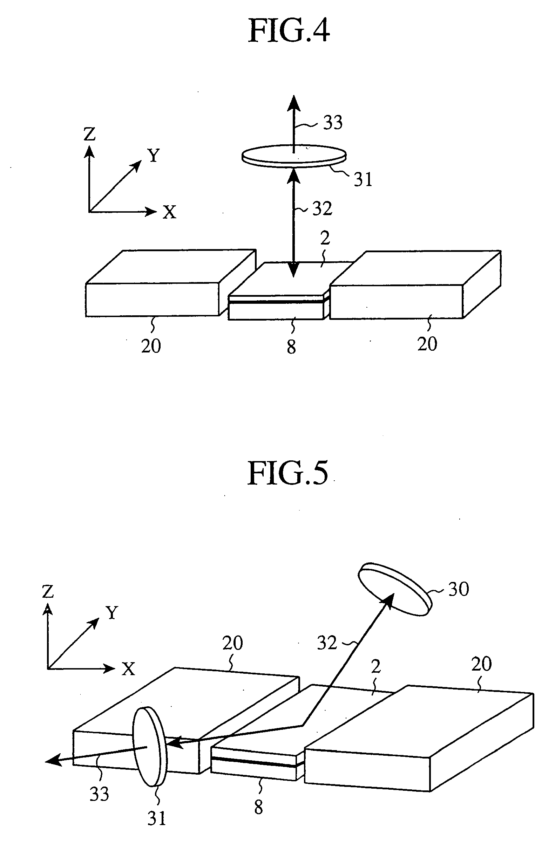

Figs. 4 and 5 are block diagrams showing the laser oscillator which employs the solid state laser pumping module 1 in accordance with this embodiment. Fig. 4 shows an example of a laser cavity in which an output mirror 31 is arranged opposite to the solid state laser chip 2, and Fig. 5 shows another example of the laser cavity when the solid state laser chip has a size in a direction of an Y axis which is larger than that in a direction of an X axis. Only minimum optical components required for performing the laser oscillation are shown in these figures, and various optical components can be further added to either of those cases.

In the case of the structure shown in Fig. 4, the output mirror 31 is arranged so that its optical axis is aligned with laser resonance light 32, and the solid state laser chip 2 is also arranged so that its optical axis is aligned with output light 33. The laser resonance light 32 goes back and forth between the solid state laser chip 2 and the output mirror 31, and the output laser light 33 is outputted from the output mirror 31. When the semiconductor laser has a length in a direction of its slow axis of (i.e., in the direction of the Y axis in the figure) which is equal to the length in a direction in which the pumping light propagates (i.e., in the direction of the X axis in the figure) and the solid state laser chip has an XY cross section close to a square in shape, the construction of the laser cavity easily makes the quality in the direction of the X axis of the laser beam obtained by the laser oscillation be equal to that in the direction of the Y axis. When other optical components are arranged so that a single mode resonator is constructed, a laser beam having equal beam diameters in the directions of the X and Y axes can be provided.

In the case of the structure shown in Fig. 5, the solid state laser chip 2 is used as one reflecting mirror having an optical gain. While resonance light 32 is almost perpendicular to the X-axis, it is inclined with respect to the Y-axis and is reflected by the solid state laser chip 2. For this reason, the optical axis of resonance light incident upon the solid state laser chip 2 is not aligned with that of resonance light which is emitted out of the solid state laser chip 2. Therefore, a reflecting mirror 30 is further arranged so as to be aligned with the optical axis of the resonance light which is incident upon or is emitted out of the solid state laser chip 2, and an output mirror 31 is arranged so as to be aligned with the optical axis of the other resonance light emitted out of the solid state laser chip. Thus, since the reflecting mirror 30 and the output mirror 31 are optically arranged so that they sandwich the solid state laser chip 2, the laser resonance light 32 passes through the solid state laser chip 2 having an optical gain two times while the laser resonance light 32 makes a round trip between the reflecting mirror 30 and the output mirror 31. For this reason, the optical gain of the solid state laser chip 2 can be assumed to have an increased optical gain as compared with the case where the solid state laser chip 2 is used as a reflecting mirror placed at an end of the laser cavity.

In addition, the laser resonance light 32 is perpendicular to the X-axis of the solid state laser chip 2, and is not perpendicular to the Y-axis of the solid state laser chip 2 and has a certain angle with respect to the Y-axis. Therefore, the solid state laser chip 2 can seemingly have a square shape other than a rectangular shape with respect to the laser resonance light 32. Therefore, this laser oscillator offers an advantage of being able to provide laser output light having an equal beam diameter in all directions in the cross section even though the size in the direction of the Y axis of the solid state laser chip 2 is larger than that in the direction of the X axis, and to provide laser output light having an equal beam diameter in all directions in the cross section even when a single mode resonator is constructed. In a case where the solid state laser chip 2 has a size in the direction of the X axis which is larger than that in the direction of the Y axis, the same advantage is provided even if the reflecting mirror 30 and the output mirror 31 are arranged so that the laser resonance light 32 is inclined with respect to the X-axis.

Next, a case where a laminated semiconductor laser bar in which two or more semiconductor laser bars are laminated in the direction of the fast axis of the semiconductor laser is used as the pumping source will be explained as a second example.

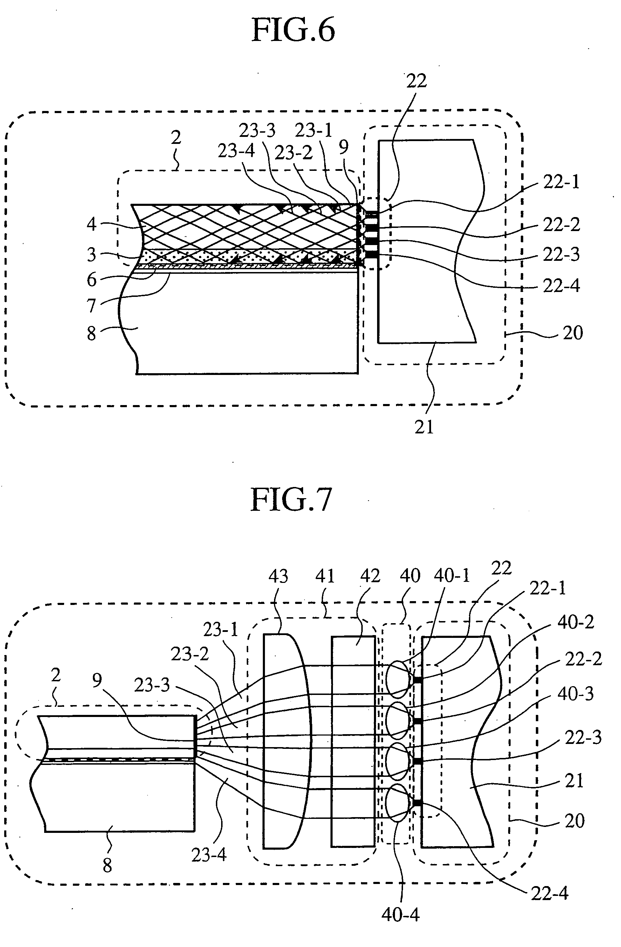

Fig. 6 is a block diagram showing a main part of the solid state laser pumping module of the second example. As semiconductor lasers which can produce high-power pumping light, there has been provided a semiconductor laser bar having a bar-shaped luminescence surface.

However, since the optical power which can be outputted from one semiconductor laser bar is restricted, there has been provided a semiconductor laser having a structure in which two or more bars are laminated in the direction of the fast axis of the semiconductor laser in order to increase its optical output. Fig. 6 shows the semiconductor laser in which four semiconductor laser bars are laminated in the direction of the fast axis of the semiconductor laser. For this reason, the optical output of the semiconductor laser becomes four times as compared with a case where only a single semiconductor laser bar is used, and high-power pumping can be achieved. Although the figure shows the case where four semiconductor laser bars are laminated, the number of semiconductor laser bars laminated in the semiconductor laser is not limited to four. The semiconductor laser can include n bars (n is an integer) laminated therein. Thus, since the first semiconductor laser bar 22.1, the second semiconductor laser bar 22.2, the third semiconductor laser bar 22.3, and the 4th semiconductor laser bar 22.4 are laminated in the direction of the fast axis of the semiconductor laser 21 or the first semiconductor laser bar 22.1 to the n-th semiconductor laser bar 22. n (n is an integer) are laminated in the direction of the fast axis of the semiconductor laser 21, the pumping light has total output power which is four times (or n times) that of pumping light generated by a single semiconductor laser bar. This type of semiconductor laser is called a laminated semiconductor laser bar.

When using such a laminated semiconductor laser bar in which a plurality of semiconductor laser bars are laminated in the direction of the fast axis of the laminated semiconductor laser bar, each pumping light beam emitted out of the semiconductor laser has a large area in the direction of the fast axis of the semiconductor laser bar. It is difficult for related art solid state pumping modules to use an optical output from a large luminescence surface with a high degree of efficiency. In contrast, in accordance with this embodiment, since the thin solid state laser medium 3 and the non-doped medium 4 are bonded to each other, the size of each pumping surface 9 in the direction of the fast axis can be enlarged by enlarging the thickness of the non-doped medium 4 while the thickness of the thin solid state laser medium 3 is kept constant. The first pumping light 23.1, the second pumping light 23.2, the third pumping light 23.3 and the fourth pumping light 23.4, or the first pumping light 23.1 to the n-th pumping light 23.n (n is an integer), which are incident upon the solid state laser chip via each pumping surface 9, propagate through the interior of the solid state laser chip 2 while being total-reflected by the upper and lower surfaces of the solid state laser chip 2, and are absorbed by the thin solid state laser medium 3 while passing through the thin solid state laser medium 3. Thus, only the arrangement of the high-power laminated semiconductor laser bar in the vicinity of the solid state laser chip 2 makes it possible to pump the thin solid state laser chip 3 with a high degree of efficiency. As a result, this second example offers an advantage of being able to provide high-power laser output light 33 with a high degree of efficiency.

Next, a case where a laminated semiconductor laser bar in which two or more bars are laminated in the direction of the fast axis of the laminated semiconductor laser bar is used as the pumping source and a cylindrical lens array and a focusing optical system are further used will be explained as a third example.

Fig. 7 is a block diagram showing a main part of the solid state laser pumping module of the third example. Pumping light outputted from each semiconductor laser bar has a large spread angle in the direction of the fast axis thereof. Therefore, in accordance with this example, a micro cylindrical lens is arranged for each semiconductor laser bar in order to collimate the pumping light emitted out of each semiconductor laser bar having a large spread angle in the direction of the fast axis thereof. Each micro cylindrical lens has a curvature in the direction of the fast axis of a corresponding semiconductor laser bar, and no curvature in the direction of the slow axis of the corresponding semiconductor laser bar. Each micro cylindrical lens, which is arranged in the vicinity of the corresponding semiconductor laser bar so that the optical axis of each micro cylindrical lens is aligned with the pumping light outputted from the corresponding semiconductor laser bar, can collimate the pumping light having a large spread angle in the direction of the fast axis, which is emitted out of the corresponding semiconductor laser bar, while each micro cylindrical lens does not have any influence upon a spread angle of the pumping light in the direction of the slow axis of the corresponding semiconductor laser bar. While the laminated semiconductor laser bar has the two or more semiconductor laser bars, two or more micro cylindrical lenses are also arranged so that they correspond to the plurality of semiconductor laser bars, respectively. The plurality of micro cylindrical lenses laminated are called a cylindrical lens array. For example, as shown in Fig. 7, the first pumping light emitted out of the first semiconductor laser bar 22-1 is collimated by the first micro cylindrical lens 40-1, the second pumping light emitted out of the second semiconductor laser bar 22-2 is collimated by the second micro cylindrical lens 40-2, the third pumping light emitted out of the third semiconductor laser bar 22-3 is collimated by the third micro cylindrical lens 40-3, and the fourth pumping light emitted out of the fourth semiconductor laser bar 22-4 is collimated by the fourth micro cylindrical lens 40-4, or the first through n-th pumping light beams respectively emitted out of the first through n-th, not shown, semiconductor laser bars are collimated by the first through n-th micro cylindrical lenses (n is an integer). Thus, since the plurality of pumping light beams respectively emitted out of the plurality of laminated semiconductor laser bars which are thus arranged are individually collimated by the cylindrical lenses of the cylindrical lens array, the plurality of light beams which are all collimated when viewed from the direction of the fast axis are outputted.

The plurality of pumping light beams which are individually collimated by the plurality of cylindrical lenses of the cylindrical lens array are collectively focused by the focusing optical system 41. The focusing optical system can focus the pumping light f rom e ach semiconductor laser bar in both the directions of the fast axis and slow axis of the pumping light source, or can focus the pumping light from each semiconductor laser bar only in the direction of the fast axis of'the pumping light source. A plurality of cylindrical lenses can be combined and arranged as the focusing optical system, or a plurality of circular lenses are concentrically arranged in a line as the focusing optical system. Furthermore, each of those lenses can have a spherical surface or an aspheric surface. In either case, in order to make each pumping light beam emitted out of the pumping source be incident upon the solid state laser chip 2 via the pumping surface 9, the focusing optical system reduces the cross-sectional size of each pumping light. In accordance with the present embodiment, the focusing optical system is comprised of two cylindrical lenses, for example. The first cylindrical lens 42 has a curvature in the direction of the slow axis of the pumping light source, and is arranged so that the optical axis thereof is aligned with all the pumping light beams collimated by the cylindrical lens array, and the second cylindrical lens 43 is arranged between the first cylindrical lens and the solid state laser chip 2 so that the optical axis thereof is aligned with all the pumping light beams collimated by the cylindrical lens array.

Each pumping light emitted out of the laminated semiconductor laser bar 22 is outputted with a slight spread angle in the direction of the slow axis of the pumping light source. Since the cylindrical lens array does not have any curvature in the direction of the slow axis of the pumping light source, each pumping light emitted out of the laminated semiconductor laser bar has no change in its optical path in the direction of the slow axis when passing through the cylindrical lens array. Each pumping light which has passed through the cylindrical lens array and is incident upon the first cylindrical lens having a curvature in the direction of the slow axis of the pumping light source propagates while being focused by a lens action of the first cylindrical lens after passing through the first cylindrical lens. Although the second cylindrical lens 43 is arranged in front of a focal point of the first cylindrical lens 42, each pumping light has no change in the optical axis thereof in the direction of the slow axis, and passes through the second cylindrical lens 43 while being focused because the second cylindrical lens 43 has no curvature in the direction of the slow axis. Thus, since each pumping light is focused in the direction of the slow axis of the pumping light source by the first cylindrical lens 42 after emitted out of the laminated semiconductor laser bar 22 (i.e., a corresponding one of the plurality of semiconductor laser bars 22-1 to 22-4), the beam diameter of each pumping light in the direction of the slow axis becomes small. For this reason, the solid state laser chip 2 can be reduced in size to smaller than the laminated semiconductor laser bar 22. All the pumping light beams can be made to be incident upon the solid state laser chip 2 via the pumping surface 9 by slightly enlarging the size of the solid state laser chip 2 in the direction of the slow axis of the pumping light source as compared with the beam size of all the pumping light beams at the focusing position. Thus, since the size of the solid state laser chip 2 in the direction of the slow axis can be reduced, the thin solid state laser medium 3 can be pumped by the high-power-density pumping light. Since the thin solid state laser medium can be pumped by the high-power-density pumping light, the low-level absorption is saturated and the amount of pumping power required for obtaining a desired optical gain is reduced. As a result, the laser oscillation threshold can be reduced and therefore the solid state laser pumping module can output a high-power laser beam with a high degree of efficiency.

The pumping light is emitted out of the laminated type semiconductor laser bar 22 with a large spread angle in the direction of the fast axis of the laminated semiconductor laser bar 22. Since the cylindrical lens array has a curvature in the direction of the fast axis of the laminated type semiconductor laser bar, the pumping light is collimated when passing through the cylindrical lens array. All the pumping light beams which are respectively emitted out of the plurality of semiconductor laser bars and are collimated by the cylindrical lens array are then incident upon the first cylindrical lens 42. Since the first cylindrical lens 42 does not have any curvature in the direction of the fast axis of the laminated semiconductor laser bar, all the pumping light beams pass through the first cylindrical lens 42 with their parallelism being maintained. All the pumping light beams are further incident upon the second cylindrical lens 43 which is so arranged as to be aligned with the first cylindrical lens. Since this second cylindrical lens has a curvature in the direction of the fast axis of the laminated semiconductor laser bar, each collimated light beam is focused to a focal position. The focal distance of the second cylindrical lens is set so as to be shorter than that of the first cylindrical lens, so that the focal position of the focusing optical system in the direction of the slow axis of the laminated semiconductor laser bar can be made to be in agreement with the focal position of the focusing optical system in the direction of the fast axis of the laminated semiconductor laser bar. As a result, all the pumping light beams can have a minimized beam diameter at the focal position of the focusing optical system. Therefore, since the area of the pumping surface 9 can be reduced by arranging the pumping surface 9 of the solid state laser chip 2 at this focal position, the solid state laser chip 2 can be pumped with high-density light power. As a result, this example offers an advantage of being able to provide a high-power laser beam with a high degree of efficiency.

Next, a case where two or more pumping sources are arranged around the solid state laser chip will be explained as a fourth example.

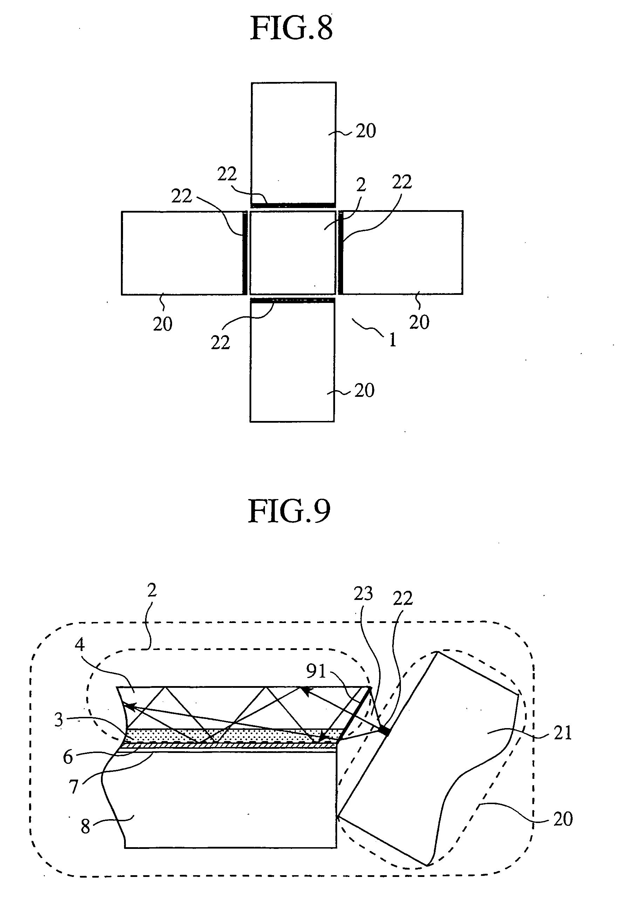

Fig. 8 is a plan view of the solid state laser pumping module of this example. When there are one or more pumping surfaces on lateral sides of the solid state laser chip, the same advantages as provided by the above-mentioned embodiment are offered. On the other hand, when two or more pumping sources are arranged around the solid state laser chip 2, the power of the pumping light can be increased and therefore a high-power laser output can be obtained. Fig. 8 shows the example in which four pumping sources are respectively arranged at four positions which are rotation symmetric around the solid state laser chip. The solid state laser chip 2 is shaped like a polygon having four or more lateral side surfaces, and four of these side surfaces are used as pumping surfaces. Since the solid state laser chip and the four pumping sources are thus arranged, the pumping power can be increased while the size of the solid state laser chip 2 is kept constant. Therefore, this example offers an advantage of being able to pump the solid state laser chip with the high-density laser power, and to provide high-power output laser light with a high degree of efficiency. Since the solid state laser chip 2 is pumped from almost the entire perimeter thereof, it has a pumped region having good rotation symmetry and a gain region having good homogeneity. Therefore, this example offers another advantage of being able to provide a high-quality high-power laser beam with a high degree of efficiency.

The solid state laser chip 2 in accordance with this embodiment has a shape like a square or rectangle, as mentioned above. As an alternative, the solid state laser chip 2 can have an arbitrary shape. For example, when the pumping source is a semiconductor laser or laminated type semiconductor laser bar, it is desirable that at least the pumping surface at least has a plane shape. On the other hand, when the pumping light is emitted out of an optical fiber and fiber bundle, the pumping light has a small cross-sectional size not only in the direction of the thickness of the solid state laser chip but in the direction of the width of the solid state laser chip. Therefore, in this case, the pumping surface does not need to have a plane shape. For example, the upper and lower plane surfaces of the solid state laser chip can be shaped like a circle or ellipse, and the pumping surface of the solid state laser chip can have a curvature. In this case, the solid state laser chip can be pumped with a high degree of efficiency.

### Embodiment 2.

Fig. 9 is a block diagram showing a main part of a solid state laser pumping module in accordance with embodiment 2. The solid state laser pumping module has the same structure as that of embodiment 1 unless explicitly shown otherwise, and offers the same advantages as provided by that of embodiment 1.

A pumping surface, which is a side surface of a solid state laser chip 2 and which is a light incidence surface via which pumping light from a pumping source is incident the solid state laser chip 2, is not parallel to a direction of the thickness of the solid state laser chip 2, but is inclined with respect to the direction of the thickness of the solid state laser chip 2. The pumping light 23 enters the interior of the solid state laser chip 2 via the inclined pumping surface 91. The pumping source 20 is arranged so as to be inclined toward a direction which is the same as that toward which the pumping surface 91 is inclined.

Semiconductor laser light is emitted out of the pumping source with a large spread angle in a direction of the fast axis of the pumping source. However, the semiconductor laser light has components which travel in straight lines without spreading at all. In a case where the solid state laser chip has a pumping surface 9 which is parallel to a direction of the thickness of a solid state laser medium 3 and pumping light is incident upon a part of the pumping surface 9 which is a part of a side surface of a non-doped medium 4, since components of the pumping light which travel in straight lines are not reflected by the upper and lower surfaces of the solid state laser chip, they propagate the interior of the solid state laser chip 2 and outgo from a surface which is opposite to the pumping surface 9 without being absorbed by the thin solid state laser medium 3. In contrast, in the solid state laser pumping module 1 in accordance with this embodiment, since the side surface which is the light incidence surface via which the pumping light 23 is incident upon the solid state laser chip is not parallel to the direction of the thickness of the solid state laser chip, but is inclined with respect to the direction of the thickness of the solid state laser chip, and the pumping source 20 is also inclined toward a direction which is the same as that toward which the pumping surface 91 is inclined, all components of the pumping light 23 emitted out of the pumping source 20 including components which spread at large angles in the direction of the fast axis of the pumping source, components which spread at small angles in the direction of the fast axis of the pumping source, and components which travel in straight lines do not travel in straight lines parallel to the upper and lower surfaces of the solid state laser chip 2 within the solid state laser chip 2. Therefore, every component of the pumping light with any spread angle passes through the thin solid state laser medium 3 and is absorbed by the thin solid state laser medium 3 while being total-reflected by the upper and lower surfaces of the solid state laser chip and therefore traveling along a bent optical path. For example, when the inclined pumping surface 91 is inclined at an angle of 30 degrees with respect to the direction of the thickness of the solid state laser medium 3 and the pumping source 20 is also inclined at the same angle toward the same direction, all the components including components which emit from a semiconductor laser bar 22 and travel in straight lines are not parallel to the upper and lower sides surface of the solid state laser chip 2 within the solid state laser chip 2 even if the pumping light 23 emitted out of the semiconductor laser bar 22 has a spread angle of ±45 degrees in the direction of the fast axis of the semiconductor laser bar 22. For example, in a case where YAG is used as the non-doped medium and the base material of the solid state laser medium 3 is also YAG, every component of the pumping light having any spread angle satisfies total reflection conditions at the upper and lower surfaces of the solid state laser chip 2 and therefore can propagate through the solid state laser chip 2 while being reflected zigzag between the upper and lower surfaces of the solid state laser chip 2 even when the pumping light has a spread angle of ±45 degrees in the direction of the fast axis of the pumping light source. Therefore, since the thin solid state laser medium 3 can absorb every component having any spread angle, the thin solid state laser medium 3 can be pumped with a high degree of efficiency. As a result, the present embodiment offers an advantage of being able to provide high-power laser light with a high degree of efficiency.

### Embodiment 3.

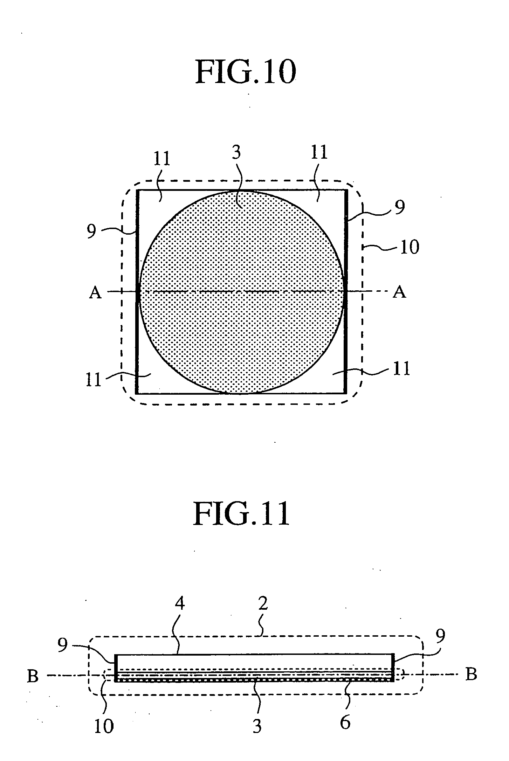

Fig. 10 and 11 are block diagrams showing a solid state laser chip of a solid state laser pumping module in accordance with embodiment 3. Fig. 10 is a cross-sectional view taken along the line B-B of Fig. 11, and Fig. 11 is a cross-sectional view taken along the line A-A of Fig. 10. The solid state laser pumping module has the same structure as that of embodiment 1 or 2 unless explicitly shown otherwise, and offers the same advantages as provided by those of embodiments 1 and 2.

In accordance with the above-mentioned embodiments, the thin solid state laser medium 3 is shaped like a square or rectangle in cross section. The thin solid state laser medium 3 can have such an arbitrary shape as a hexagon, octagon, circle, or ellipse, in cross section. On the other hand, the solid state laser chip 2 needs to have a pumping surface 9 which is a plane surface because it is pumped by, for example, a bar-shaped semiconductor laser. For this reason, a thin solid state laser medium composite material 10 can be used instead of using the single thin solid state laser medium 3 of the above-mentioned embodiments. The thin solid state laser medium composite material 10 is comprised of a thin solid state laser medium 3 and second non-doped media 11. The second non-doped media 11 having the same thickness as the thin solid state laser medium 3, and are arranged around the perimeter of the thin solid state laser medium 3. The thin solid state laser medium 3 and the second non-doped media 11 are bonded to each other at their boundary surfaces parallel to a direction of the thickness of the thin solid state laser medium 3 using a diffusion bonding technique, optical contact technique, or a technique for manufacturing ceramics, and the boundary surfaces have a very small optical loss. Since the second non-doped media 11 are arranged around the perimeter of the thin solid state laser medium 3 having an arbitrary shape, the thin solid state laser medium composite material 10 can be formed so as to have lateral plane side surfaces regardless of the shape of the thin solid state laser medium 3 by making the shapes of the second non-doped media 11 match with that of the thin solid state laser medium 3. Therefore, the solid state laser chip can be pumped by pumping light from the bar-shaped semiconductor laser which is incident thereupon via two pumping surfaces 9 which are lateral side surfaces of the thin solid state laser medium composite material in the direction of the thickness of the thin solid state laser medium composite material. The thin solid state laser medium composite material 10 is bonded to a non-doped medium 4 over the whole of an upper surface thereof. The thin solid state laser medium composite material 10 and the non-doped medium 4 are bonded to each other using a bonding technique, such as a diffusion bonding technique, an optical contact technique, or a technique of manufacturing ceramics, as in the case of bonding the solid state laser medium 3 and the non-doped medium 4 to each other. Therefore, boundary surfaces of the thin solid state laser medium composite material 10 and the non-doped medium 4 have a very small optical loss. In the solid state laser chip 2, the thin solid state laser medium composite material 10 and the non-doped medium 4 are bonded to each other over the whole of their boundary surfaces, and a reflecting coating 6 for reflecting light having the same wavelength as laser light to be pumped is formed on a lower surface of the thin solid state laser medium composite material 10 which is opposite to the boundary surface of the thin solid state laser medium composite material 10 to which the non-doped medium 4 is bonded.

An example of the thin solid state laser medium composite material 10 is shown in Fig. 10. In this example, the solid state laser medium 3 has a circular shape. As an alternative, the solid state laser medium 3 can have a polygonal or elliptic shape. Fig. 11 shows a side view of the solid state laser chip 2 which employs the thin solid state laser medium composite material 10. The boundary surface of the thin solid state laser medium composite material 10 which is bonded to the non-doped medium 4 has a rectangular shape. In this cross section, the thin solid state laser medium 3 included in the thin solid state laser medium composite material 10 has a circular shape, the second non-doped media 11 are surrounded by the circular thin solid state laser medium 3, and the thin solid state laser medium composite material 10 has a rectangular shape. The rectangular thin solid state laser medium composite material 10 and the non-doped medium 4 having the same shape as the thin solid state laser medium composite material 10 are bonded to each other over the whole of their boundary surfaces, and the reflecting coating 6 for reflecting light having the same wavelength as laser light to be pumped is formed on the lower surface of the thin solid state laser medium composite material 10 which is opposite to the boundary surface of the thin solid state laser medium composite material 10 to which the non-doped medium 4 is bonded. Lateral side surfaces of the solid state laser chip 2 which is thus constructed serve as the pumping surfaces 9. Since the solid state laser chip 2 is constituted as mentioned above, it has a circular gain region. Therefore, when carrying out laser oscillation, the solid state laser chip can provide output laser light 3 having a concentric circular shape without having to use a special measure for arranging a circular aperture in the laser cavity thereof so as to shape the output laser light into a circle in cross section. If the solid state laser chip has a rectangular gain region and provides circular output laser light, since energy is extracted only from a part of the thin solid state laser medium in which the circular laser light and the gain region overlap each other, the rectangular gain region has a portion from which energy cannot be extracted even though pumped by the pumping light. As a result, the efficiency of extraction of energy may be reduced in this case. In contrast, since the thin solid state laser medium 3 in accordance with this embodiment can have a circular shape and hence a circular gain region, the percentage by which the circular laser beam and the gain region overlap each other is high and therefore a high degree of efficiency of extraction of energy is obtained. Therefore, the present embodiment offers an advantage of being able to provide high-power laser light with a high degree of efficiency. Industrial Applicability

As mentioned above, the solid state laser pumping module in accordance with the present invention can be applied to a laser oscillator or a laser amplifier, and is suitable for providing high-power laser light with a high degree of efficiency.

## Claims

1. A solid state laser pumping module including a plate-shaped thin solid state laser medium, a reflecting surface arranged on a plane surface of said thin solid state laser medium, a cooling means bonded to said reflecting surface, a pumping source for providing pumping light to said thin solid state laser medium, laser light being incident upon a laser light incidence surface which is opposite to said reflecting surface, **characterized in that** said thin solid state laser medium is a plate whose at least a part on a side of said reflecting surface has an active material doped thereinto, a plate-shaped non-doped medium is disposed on another plane surface of said thin solid state laser medium which is opposite to said plane surface of said thin solid state laser medium on which said reflecting surface is disposed, and said two plates are optically bonded to each other.

2. The solid state laser pumping module according to Claim 1, **characterized in that** said module has a pumping surface via which the pumping light is introduced into a side surface of said plate-shaped thin solid state laser medium, and said pumping light propagates through said thin solid state laser medium and pumps said thin solid state laser medium while being reflected between said reflecting surface disposed on said thin solid state laser medium and said laser light incidence surface.

3. The solid state laser pumping module according to Claim 2, **characterized in that** said pumping surface is formed at a certain angle with respect to a direction of normal to said reflecting surface, and the pumping light emitted out of said pumping source has an optical axis which is substantially parallel to the normal to said pumping surface.

4. The solid state laser pumping module according to Claim 2, **characterized in that** either of diffusion bonding, optical contact, and a ceramic manufacturing means is used as a means for bonding the plate whose at least a part on a side of said reflecting surface has an active material doped thereinto to the plate-shaped non-doped medium disposed on the other plane surface of said thin solid state laser medium which is opposite to said plane surface of said thin solid state laser medium on which said reflecting surface is formed.

5. The solid state laser pumping module according to Claim 1, **characterized in that** the plane surfaces of said thin solid state laser medium are inclined with respect to each other.

6. The solid state laser pumping module according to Claim 1, **characterized in that** a plurality of said pumping surfaces are arranged on a side surface of said thin solid state laser medium, and a plurality of pumping sources for outputting pumping light to said plurality of pumping surfaces, respectively are arranged.

7. The solid state laser pumping module according to Claim 1, **characterized in that** said active material of said thin solid state laser medium is Yb.
